Europäisches Patentamt

European Patent Office

Office européen des brevets

(11) Veröffentlichungsnummer: **0 087 796**
**B1**

(12) **EUROPÄISCHE PATENTSCHRIFT**

(45) Veröffentlichungstag der Patentschrift: **17.05.89**

(21) Anmeldenummer: **83101955.9**

(22) Anmeldetag: **28.02.83**

(51) Int. Cl.⁴: **H 01 L 21/60,** H 01 L 23/54,
H 01 L 21/68

(54) **Filmträger für ein elektrisches Leiterbild.**

(30) Priorität: **02.03.82 DE 3207450**

(43) Veröffentlichungstag der Anmeldung:
**07.09.83 Patentblatt 83/36**

(45) Bekanntmachung des Hinweises auf die
Patenterteilung:
**17.05.89 Patentblatt 89/20**

(84) Benannte Vertragsstaaten:
**AT BE CH DE FR GB IT LI NL**

(56) Entgegenhaltungen:
DE-A-2 500 180
US-A-3 868 724
US-A-4 234 666

WESTERN ELECTRIC ENGINEER, Band 20, Nr.
4, Oktober 1976, Seiten 16-21, Western Electric
Company, Inc., New York, US; R.F. GRUSZKA:
"Preloading complaint bonding tape with
beam-lead integrated circuits"

IEEE 27th ELECTRONIC COMPONENTS
CONFERENCE, 16.-18. Mai 1977, Arlington,
VA., Seiten 34-47, New York, US; J.M. SMITH
u.a.: "Hybrid microcircuit tape chip carrier
materials/processing trade-offs"

(73) Patentinhaber: **Siemens Aktiengesellschaft**
**Berlin und München**
**Wittelsbacherplatz 2**
**D-8000 München 2 (DE)**

(72) Erfinder: **Fritz, Otmar, Dipl.-Ing.**
**Johann-Hackl-Ring 64**
**D-8011 Neukeferloh (DE)**

Courier Press, Leamington Spa, England.

**Beschreibung**

Die Erfindung betrifft einen Filmträger nach dem Oberbegriff des Patentanspruchs 1.

Ein integrierter Baustein kann bekanntlich aus einer Funktionsanordnung, beispielsweise aus einem integrierten Schaltkreis oder einem Widerstandsnetzwerk, und Leitungen für die Verbindung der Funktionsanordnung mit den Außenanschlüssen des integrierten Bausteines bestehen. Bei der Filmmontage von integrierten Bausteinen kann das Leiterbild aus geätzten Leiterbahnen auf einem elektrisch isolierenden Träger aufgebracht sein. Der Träger kann zur Aufnahme einer großen Anzahl von Leiterbildern als Filmträger gefertigt sein. Ein Schaltkreis, der mit einem Leiterbild auf einem Filmträger kontaktiert ist, wird als Mikropack bezeichnet. Die Herstellung eines Mikropacks erforderte eine genaue Justierung des Filmträgers in bezug auf die Anschlüsse des integrierten Schaltkreises, besonders wenn Schaltkreise mit einer großen Anzahl von Anschlüssen verwendet werden.

Als Filmträger kann ein Film mit der Breite eines Kinofilms, beispielsweise mit einer Breite von 35 mm, verwendet werden. Der Filmträger kann mit Randperforationen versehen sein, wei sie das Herstellformat für Schmalfilme aufweist. Schmalfilme, beispielsweise mit einer Breite von 8 mm, können aus einem breiteren Film hergestellt werden, der in entsprechende schmale Streifen zerschnitten wird.

Aus der DE—OS 25 00 180 ist ein Verfahren und eine Vorrichtung zum Verarbeiten von gehäuselosen IC-Chips bekannt, bei dem als Träger der Chips ein Filmmaterial verwendet wird, das eine Randperforation aufweist. Dabei dient jedes vierte Loch der Randperforation als Justieröffnung, die nicht für einen Transport des Filmstreifens verwendet wird.

Aus der US—PS 4 234 666 ist ein ähnlicher Filmträger wie aus der vorhergehenden Entgegenhaltung bekannt, jedoch wird dort die Perforation ausschließlich zu Transportzwecken benützt. Als Film kann auch ein 35 mm Kinofilm verwendet werden.

Weiterhin ist es aus der Druckschrift IEEE 27th Electronics Components Conference, Seiten 34 bis 47 bekannt, außer Kinofilmen auch andere Filmbreiten, beispielsweise Industrieschmalfilme mit 8 mm Breite zu verwenden, wobei die Randperforationen lediglich zum Transport verwendet werden und offenbar in ihren Abmessungen der jeweiligen Filmbreite angepaßt sind.

Für eine genaue Justierung bei der Herstellung eines Mikropacks sind Perforationslöcher als Bezugspunkte nicht ausreichend geeignet. Der Grund dafür liegt primär in den kleinen Abmessungen der Perforation, welche für die Justierung entsprechend fein ausgelegte Werkzeuge erfordern. Das hat zur Folge, daß die Perforationslochungen bereits vor der Montage des Mikropacks, beisielsweise durch Transportvorgänge oder während der Montage, beschädigt werden können. Diese Beschädigungen können dann zu Ungenauigkeiten bei der Montage führen. Besonders bei einer automatisch ablaufenden Montage ist eine gleichmäßige hohe Genauigkeit erforderlich.

Bei den bekannten Filmträgern, deren Randperforation größere als bei Schmalfilmen übliche Lochungen aufweist, wird ein beträchtlicher Teil der Filmfläche für Transportzwecke belegt und steht daher nicht für das Tragen der Leitungsbilder zur Verfügung. Besonders bei Leitungsbildern mit einer großen Anzahl von Leitungen, beispielsweise von 64 oder 240 Leitungen, ist eine möglichst große Flächenausnutzung erforderlich.

Der Erfindung lad daher die Aufgabe zugrunde, einen Filmträger der eingangs genannten Art anzugeben, welcher bei möglichst großer Flächenausnutzung eine höhere Justiergenauigkeit bei der Montage eines Mikropacks gewährleistet.

Diese Aufgabe wird erfindungsgemäß durch die kennzeichnenden Merkmale des Patentanspruchs 1 gelöst.

In einer Weiterbildung der Erfindung sind die Justieröffnungen mittig zu zwei Öffnungen der Randperforation angeordnet. Vorteilhafterweise sind die Justieröffnungen mittig zu einer Strukturmittellinie des Literbildes angeordnet.

Das hat den Vorteil, daß die auf dem Filmträger zur Verfügung stehende Fläche welche mit dem Leitebild belegt werden kann, nicht wesentlich eingeschränkt wird. Außerdem wird erreicht, daß andere Filmträger, welche eine Perforation wie ein Kinofilm und ein Leiterbild mittig zur Perforation aufweisen, gleiche Bezugspunkte haben. Wenn gleiche Abmessungen im Kontaktierbereich des Mikropacks vorliegen, so kann die Montage des Mikropacks mit den gleichen Werkzeugen und Einrichtungen erfolgen. Beispielsweise ist bei einer Bandverarbeitung nur ein Austausch der Vorschubrollen erforderlich. Durch die mittige Anordnung der Justieröffnungen zwischen zwei Öffnungen der Randperforation und mittig zum Leiterbild ist die Justieröffnung unabhängig on der Länge (in Transportrichtung des Filmträgers) des Mikropacks.

Im folgenden wird die Erfindung anhand eines vorteilhaften Ausführungsbeispieles weiter beschrieben.

Die Fig. zeigt einen Filmträger mit einem Leiterbild und einem integrierten Schaltkreis (Mikropack).

Die Fig. zeigt einen Filmträger 1, der aus einem elektrisch isolierenden Material besteht. Der Filmträger 1 trägt ein geätztes Leiterbild 5 und eine Funktionseinheit 4. Die Funktionseinheit 4 kann beispielsweise aus einem integrierten Schaltkreis oder einem Widerstandsnetzwerk bestehen. Das Leiterbild 5 weist Leitungen auf, über welche die Funktionseinheit 4 mit den Außenanschlüssen des integrierten Bausteins verbunden sind. Die Verbindung der Leiterbahnen 8 mit der Funktionseinheit 4, erfolgt über eine Innenkontaktierung 6. Die Verbindung der Leiterbahnen 8 mit den Anschlüssen des integrierten Bausteins erfolgt über die Außenkontaktierung 7. Der Filmträger 1 kann in Transportrichtung (Pfeil) eine große Anzahl von Leiterbildern 5 oder von Leiterbildern 5 zusammen mit Funktionseinheiten 4 aufweisen.

Der Filmträger 1 hat quer zur Transportrichtung die Breite eines Kinofilms, die beispielsweise 35 mm beträgt. Der Filmträger 1 ist in Transportrichtung mit einer Randperforation 2 versehen, wie sie das Herstellformat für Schmalfilme aufweist. Beim Herstellformat für Schmalfilme können die Lochungen für die Randperforation entlang des einen Randes einen Abstand von 0,787 mm, eine Seitenlänge von jeweils 1,143 mm und einen Eckradius 0,13 mm aufweisen. Entlang des anderen Randes können die Lochungen eine Entfernung vom Rand von 1,27 mm, eine Breite von 0,914 mm und eine Länge von 1,143 mm aufweisen. Der Abstand von einer Seite der Lochungen zur entsprechenden Seite der benachbarten Lochung kann 4,234 mm betragen. Mittig zwischen zwei Lochungen 2 der Randperforation sind auf dem Filmträger 1 zwei Justieröffnungen 3 angebracht. Ihre Größe und ihre Anordnung bezüglich der Ränder des Filmträgers 1 entspricht einem Transportloch eines Kinofilms. Die Justieröffnungen können eine Länge von 2,8 mm, eine Breite von 1,98 mm und Abrundungen mit einem Radius von 0,5 mm aufweisen. Die Schmalseiten verlaufen parallel zu den Rändern des Filmträgers 1. Die Justieröffnungen 3 sind mittig zu einer Strukturmittellinie 9 ausgerichtet. Die Strukturmittellinie 9 ist eine quer zur Transportrichtung verlaufende Symmetrielinie des Lieterbildes 5 und der Funktionseinheit 4.

Die Justieröffnungen (3) liegen sich bezüglich der Ränder des Filmträgers (1) gegenüber.

Weitere Maßangaben bezüglich der Randperforation für das Herstellformat des Schmalfilmes können beispielsweise der Deutschen Industrienorm DIN 15851 entnommen werden. Weitere Maßangaben bezüglich der Justieröffnung 3 können beispielsweise der ISO-Norm 491—1978 E, Typ P entnommen werden.

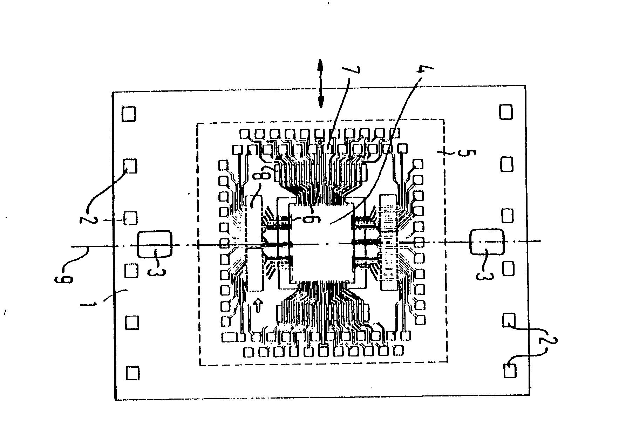

## Patentansprüche

1. Filmträger mit mindestens einem Leiterbild (5) sowie einer Randperforation (2) zum Transport und mit mindestens zwei Justieröffnungen (3), die einander gegenüberliegend an den Rändern des Filmträgers angeordnet sind, dadurch gekennzeichnet, daß der Filmträger (1) die Breite eines Kinofilms aufweist, daß die Randperforation (2) für den Transport dem Herstellungsformat für Schmalfilme entspricht, daß die Justieröffnungen (3) jeweils die Größe eines Transportloches eines Kinofilms aufweisen, welche bezüglich der Ränder des Filmträgers (1) wie die Transportlöcher eines Kinofilms angeordnet sind.

2. Filmträger nach Anspruch 1, dadurch gekennzeichnet, daß die Justieröffnungen (3) mittig zu zwei Lochungen (2) der Randperforation angeordnet sind.

3. Filmträger nach Anspruch 1 oder 2, dadurch gekennzeichnet, daß die Justieröffnungen (3) mittig zu einer Strukturmittellinie (9) des Leiterbildes (5) angeordnet sind.

## Revendications

1. Support en forme de pellicule comportant au moins une configuration de conducteurs (5) ainsi que des perforations marginales (2) utilisées pour l'entraînement, et au moins deux ouvertures d'ajustement (3), qui sont disposées à l'opposé l'une de l'autre au niveau des bords du support en forme de pellicule, caractérisé par le fait que le support en forme de pellicule (1) possède la largeur d'une pellicule cinématographique, que les perforations marginales (2) utilisées pour l'entraînement correspondent au format de fabrication pour des pellicules de format réduit, et que les ouvertures d'ajustement (3), qui sont disposées, par rapport aux bords du support en forme de pellicule (1), de la même manière que les trous d'entraînement d'une pellicule cinématographique, possèdent respectivement la taille d'un tel trou.

2. Support en forme de pellicule suivant la revendication 1, caractérisé par le fait que les ouvertures d'ajustement (3) sont disposées dans une position médiane entre deux trous (2) des perforations marginales.

3. Support en forme de pellicule suivant la revendication 1 ou 2, caractérisé par le fait que les ouvertures d'ajustement (3) sont disposées en étant centrées sur une ligne médiane (9) de la structure de la configuration de conducteurs (5).

## Claims

1. Film carrier having at least one conductor pattern (5), as well as an edge perforation (2) for transport and having at least two adjustment openings (3), which are arranged opposite each other on the edges of the film carrier, characterized in that the film carrier (1) has the width of a cine film, in that the edge perforation (2) for transport corresponds to the production format for narrow-gauge films, in that the adjustment openings (3) have in each case the size of a sprocket hole of a cine film, which are arranged with respect to the edges of the film carrier (1) like the sprocket holes of a cine film.

2. Film carrier according to Claim 1, characterized in that the adjustment openings (3) are arranged centrally with respect to two holes (2) of the edge perforation.

3. Film carrier according to Claim 1 or 2, characterized in that the adjustment openings (3) are arranged centrally with respect to a structure centre line (9) of the conductor pattern (5).